# EUROPEAN PATENT SPECIFICATION

(11) **EP 2 403 148 B1**
(45) Date of publication and mention of the grant of the patent: **16.07.2014**
(21) Application number: 10167987.6
(22) Date of filing: 30.06.2010
(51) Int. Cl.: H04B 1/036, H05K 7/20

(54) **Housing**
Gehäuse
Boîtier

(43) Date of publication of application: 04.01.2012
(73) Proprietor: Nokia Solutions and Networks Oy, 02610 Espoo (FI)
(72) Inventor: Schuster, Siegwald, 82166, Gräfelfing (DE)
(74) Representative: Borgström, Markus

(56) References cited:
- WO-A1-2008/133399
- DE-A1-102008 002 789
- US-A- 5 414 591
- US-B1- 6 896 612

## Description

The invention relates to a housing, in particular a housing of a telecommunication device.

Cooling of telecommunication equipment requires highly reliable solutions in all modes of operation. Hence, even when a cooling component is replaced, the telecommunication equipment needs to remain active.

Cooling can be achieved by using fans, which have a limited lifetime and have to be replaced at more or less regular intervals. In order to allow for an easy replacement of the fans, at least one fan can be mounted on a unit, e.g., on a tray, a drawer or an insertion slide-in, which can be pulled out of the telecommunication equipment. During such fan replacement, the telecommunication equipment remains in operation and the remaining fans take over the job of the at least one fan that is being replaced.

It is a disadvantage, however, that during such unit replacement the cooling efficiency suffers, because the air to be transported towards the components that require cooling partially escapes via the opening left by the unit removed.

Thus, the airflow reaching the components that require cooling is reduced when a fan unit is pulled out of the telecommunication equipment. This could be a critical issue, because such components can be ASICs that require permanent intensive cooling. Furthermore, the telecommunication equipment is construed as a compact rack with a high density of electrical components. In case of an overheating of the rack, several telecommunication equipment may fail, thus affecting a huge number of calls or subscribers. Hence, an outage in particular based on an overheated electrical component has to avoided.

The problem to be solved is to overcome the disadvantage mentioned above and in particular to provide an efficient solution to improve cooling even during a replacement of a fan unit.

The state of the art may be given by the following documents:
- The US patent US 5 414 591 A discloses a cooling system where the cooling air can pass between adjacent containments thus ensuring a minimum cooling even in case that a blast device fails.
- The German application DE 10 2008 002789 A1 discloses an arrangement of air conditioning devices in racks where an improved air flow optimizes the heat transfer away from the electronic devices.
- The international application WO 2008/133399 A1 discloses an air conditioning system for communication equipment where opening/closing units control the air flows in said air conditioning system.
- The US patent US 6 896 612 Bl discloses louvers which open a sealed electronic equipment enclosure in case of a cooling system failure towards the ambient room so that intruding room air ensures emergency cooling.

The problem cited above is solved according to the features of the independent claim 1. Further embodiments are defined in the depending claims 2 to 12.

In order to overcome this problem, a housing, in particular of a telecommunication device or for a telecommunication equipment, is suggested,
- comprising a flow resisting means between an active cooling device and a cooling area,
- wherein the flow resisting means is arranged such that it provides less flow resistance towards the cooling area than in the opposite direction.

It is noted that the flow resisting means can be flow resisting in both directions and in particular flow prohibiting towards the opposite direction, i.e. from the cooling area to the active cooling device (for example when the active cooling device is off or extracted from the housing). The cooling area may in particular be an area of the housing equipped with electronic equipment that in particular requires constant cooling. For the purpose of cooling the housing is usually equipped with means that allow for an airflow to run through the housing, in particular openings that allow the active cooling device to suck in air and another opening that allows this airflow (after it has cooled the electronic equipment) to escape the housing.

Advantageously, based on the solution suggested, the airflow is at least partially hampered from evading the housing before it has passed the electronic equipment and thus before it could have contributed to the cooling effect.

In an embodiment, the active cooling device comprises at least one fan that is arranged on a replaceable unit.

In particular, several fans of different or same size and/or cooling capability can be mounted on the replaceable unit. Said replaceable unit can be a tray or a drawer or an insertion slide-in. The replaceable unit can be extracted from the housing. The replaceable unit can be used to replace the at least one fan.

It is noted that several flow resisting means can be provided, e.g., per fan or per several fans. Hence, several flow resisting means can be arranged or mounted in the housing between the (at least one) active cooling device and the cooling area, in particular the electronic equipment that requires cooling.

In another embodiment, the housing is arranged to contain several replaceable units.

In this regard, several replaceable units can be arranged (e.g., at or near a bottom of the housing) in particular adjacent to one another. The several replaceable units together provide the cooling airflow that is fed towards the electronic equipment.

Hence, if one of the replaceable units is (temporarily, e.g., for replacement purposes of the at least one fan) removed from the housing, the (at least one) flow resisting means hampers the airflow generated by the active fans from escaping through the opening left by the replaceable unit that is removed for repair purposes. These active fans may be controlled such that they provide a sufficient airflow to ensure an acceptable cooling level for the electronic equipment. Thus, the replacement and/or repair of the fans of the replaceable unit that has been removed from the housing can take as long as necessary.

In a further embodiment, the flow resisting means comprises at least one layer, plate and/or foil.

The flow resisting means can be built integrally as or from a single piece of (e.g., partially elastic or flexible) material. Also, the flow resisting means can comprise several parts of the same or of different material. The flow resisting means may in particular comprise several separate elements, each hampering the airflow in a manner described herein.

In a next embodiment, said flow resisting means comprises several laterally protruding portions, which are moveable towards the cooling area by the airflow provided by said active cooling device(s).

For that purpose the frame may comprise at least one bar, to which the flow resisting means can be attached. The frame or the bar of the frame may support the moveable part of each protruding portion. By providing such support, the airflow is hindered to flow from the cooling area towards (the area of) the active cooling device (in case this active cooling device is switched off or not present).

It is also an embodiment that the laterally protruding portions in their end range lie on top of the frame so that they are moveable towards the cooling area by an airflow.

Pursuant to another embodiment, the laterally protruding portions are arranged offset against each other, in particular at an alternating pattern.

The laterally protruding portions may be arranged as suggested at an alternating pattern along the length of the bar and/or the frame.

According to an embodiment, the laterally protruding portions cover a part of the flow cross-section, said flow cross-section being caused by the active cooling device.

The part of the flow cross section covered by the protruding portions may amount up to 100%, in particular more than 20%. Preferably, around 50% of said flow cross section can be covered.

The flow resisting means may in particular cover the full area above the active cooling devices or a portion thereof. The flow resisting means can be of different shape or pattern. It may have openings (e.g., holes and/or slots) and/or cover only a certain area between the active cooling device and the cooling area.

According to another embodiment, the housing comprises electronic equipment that is arranged within the cooling area.

Such electronic equipment may be any device that requires cooling, e.g., processors, converters, controlling devices, integrated circuits, electronic switches, etc.

In yet another embodiment, the flow resisting means is flexible or hinged towards the cooling area.

According to a next embodiment, the flow resisting means comprises a flexible part or a deformable part that is less rigid so that it is moveable towards the cooling area by an airflow.

Pursuant to yet an embodiment, the flow resisting means comprises a hinge that is moveable towards the cooling area by an airflow.

According to a further embodiment, the housing comprises a telecommunication equipment.

Embodiments of the invention are shown and illustrated in the following figures:
- Fig.1: shows a schematic diagram comprising a frame with several bars, wherein a flow resisting means is attached by fasteners to the bar;
- Fig.2: shows the arrangement according to Fig.1, wherein an airflow moves the laterally protruding portions of the flow resisting means upwards towards a cooling area;
- Fig.3: shows a schematic diagram comprising a part of a housing with a removable tray, which comprises two fans, wherein in case of a failure of a fan (or before an actual failure occurs), the tray can be removed and the fan can be replaced.

A telecommunication equipment comprises at least two (replaceable) units, each comprising at least one fan. The units provide an airflow that ensures cooling of the components of the telecommunication equipment, e.g., electronic elements. The fans can be controlled in a way that the airflow is adjusted pursuant to a temperature of the components that need cooling (or based on an ambient temperature).

Also, the fan may provide a functionality that indicates that it reaches its end of lifetime. This indication can be used to trigger a replacement information, e.g., via an indicator or a message that is sent by the telecommunication equipment towards a maintenance entity. Hence, the maintenance entity may trigger a job to replace the unit of the fan that will soon reach its end of lifetime.

As an alternative, a faulty fan can be determined by a change of temperature distribution within the telecommunication equipment. In this case, a replacement of the unit with the faulty fan can be triggered.

It is also an alternative that the units are replaced periodically, e.g., well before the individual fan malfunctions due to reaching its end of lifetime.

Also, a replacement of a unit comprising at least one fan may be triggered by several of the aforementioned events.

It is noted that each unit may comprise one fan or several fans. The telecommunication equipment may comprise several such units.

The at least one fan of a replaceable unit may provide an airflow towards the electrical elements of the telecommunication equipment. Between the at least one fan and the electrical elements that require cooling a flow resisting means is arranged that provides less flow resistance towards the electrical element than in the opposite direction. The flow resisting means is in particular (at least partially) flexible, elastic and/or hinged (towards the electrical element). The flow resisting means can be a layer or a plate, in particular a foil.

A frame can be placed inside the telecommunication equipment between the (electrical) element that requires cooling and the fan(s). The flow resisting means can be mounted on top of the frame. The frame can be arranged in proximity to the fans.

An active fan provides an airflow towards the flow resisting means, which flexes towards the electrical element and allows the airflow to largely pass the flow resisting means. In case the unit with the at least one fan is extracted, the airflow from the remaining units presses in the opposite direction against the flow resisting means, which at least partially blocks this air from evading the telecommunication equipment via the opening left by the unit with the fan(s) to be replaced that has been extracted from the equipment.

It is noted that based on the design or material used as flow resisting means, the level of blocking the air from evading the equipment via said opening can be adjusted.

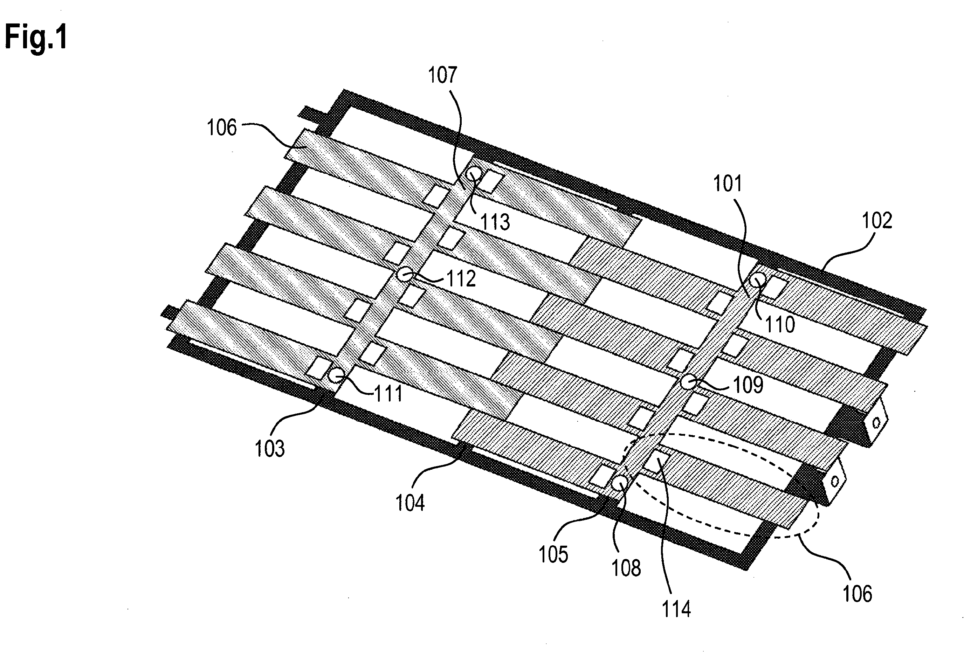

**Fig.1** shows a schematic diagram comprising a frame 102 with several bars 103, 104, 105, wherein a flow resisting means 101 is attached by fasteners 108, 109 and 110 to the bar 105 and a flow resisting means 107 is attached by fasteners 111, 112 and 113 to the bar 103.

Each flow resisting means 101, 107 comprises several laterally protruding portions 106, which are moveable upwards towards a cooling area (not shown in Fig.1).

The laterally protruding portion 106 can be of a flexible or an elastic material or it can comprise a flexible or an elastic part that enables such movement towards the cooling area. The movement of the protruding portion 106 in the opposite direction is limited by the frame 102 (or its bars).

It is noted that the protruding portions can be of an inflexible material, but comprise a hinge that allows the movement of a part of the protruding portion upwards.

The laterally protruding portion 106 comprises an opening 114 near the bar 105 so that it is less rigid and more elastic and can more easily be bent upwards by an airflow. Instead of such opening 114 a reduced size or a reduced diameter (thickness) near the bar 105 can be used to allow the protruding portion 106 to be easily moved by said airflow.

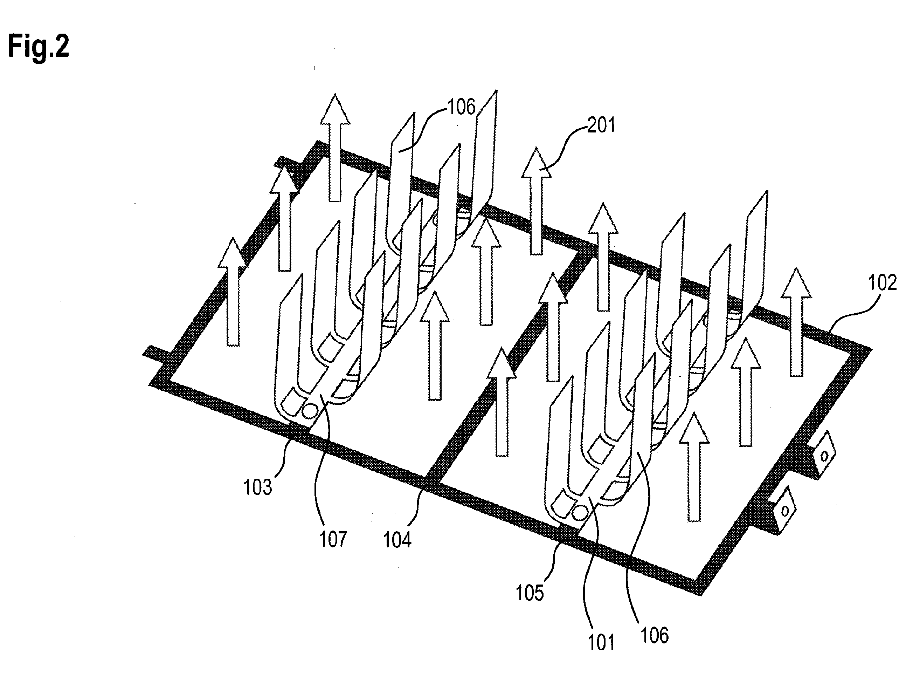

**Fig.2** shows the arrangement according to Fig.1, wherein an airflow 201 moves the laterally protruding portions 106 of the flow resisting means 101, 107 upwards. The airflow is caused by fans (not shown in Fig.2) that are arranged below the frame 102.

Due to the structure of the laterally protruding portions 106 they can easily bend at their structurally weak spot (the opening 114, see also Fig.1) and provide only little flow resistance against the airflow 201 from the fans.

Without such airflow 201, the laterally protruding portions 106 return to the position as shown in Fig.1. Here, an airflow in the opposite direction compared to the airflow 201 is substantially hampered by the laterally protruding portions 106 to pass the flow resisting means 101, 107.

As shown in Fig.1, the laterally protruding portions 106 are arranged offset against each other at an alternating pattern along the bars 103 and 105.

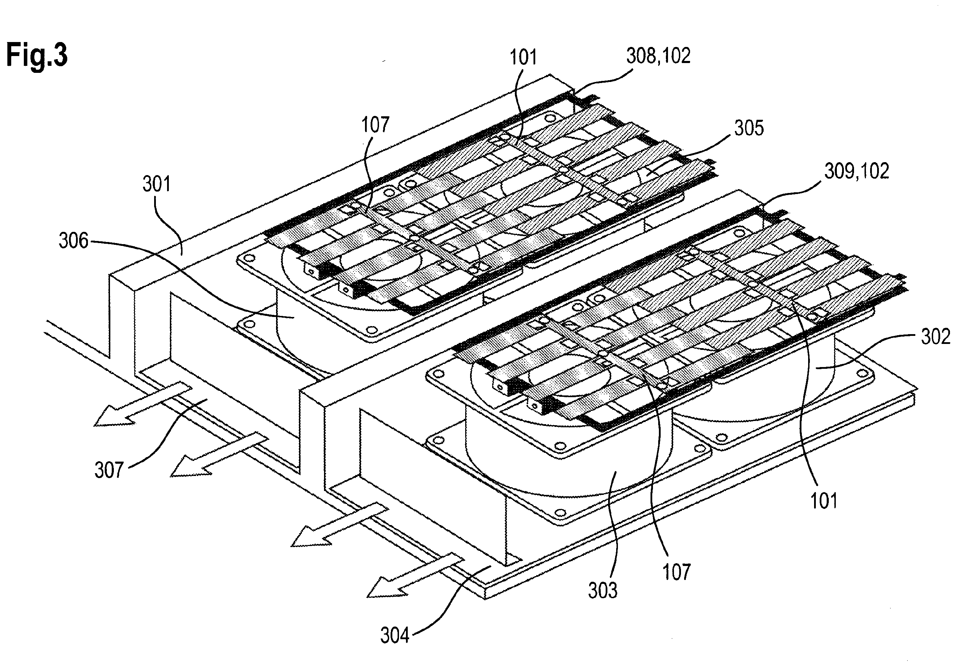

**Fig.3** shows a schematic diagram comprising a part of a housing 301 with a removable tray 307, which comprises two fans 305, 306. In case of a failure of the fan 305, 306 (or before an actual failure occurs), the tray 307 can be removed and the fans 305, 306 (or only one of the fans) can be replaced. It is also an option that the whole tray 307 is replaced by another tray, e.g., with different (in particular new) fans.

The same applies for a tray 304 comprising two fans 302, 303.

A frame 308 is arranged above the fans 305, 306 and another frame 309 is arranged above the fans 302, 303. The frames 308, 309 are each similar to the frame 102 as shown and explained above (see in particular Fig.1 and Fig.2). The frames 308, 309 are mounted inside the housing 301 and remain in the housing in case the tray 304, 307 is removed.

Fig.3 shows a scenario with all fans 302, 303, 305, 306 being inactive. Above the fans, in an upper area of the housing 301 is a cooling area, i.e. an area comprising in particular electronic equipment that needs constant cooling. Such cooling is provided by the fans 302, 303, 305, 306, which may be controlled dependent on the temperature inside the housing, the temperature of the electronic equipment and/or the status of the fans.

The cooling area is supplied by an airflow generated by all fans 302, 303, 305, 306, i.e. airflows provided by the different fans of the different drawers may in combination contribute to the cooling effect required for the cooling area. In case the tray 304 is removed from the housing 301, the airflow generated by the tray 307 may at least partially (without the flow resisting means) escape via the opening left by the tray 304 and thus a part of the airflow would not reach the cooling area thus significantly reducing the overall cooling effect that is provided for the electronic equipment.

Even in case a fan control sets the fans of the tray 307 to full power when the tray 304 is being removed, without the solution provided herein, the cooling supplied by the fans of the tray 307 may not suffice and the electronic equipment may heat up beyond an admissible temperature threshold.

The flow resisting means 101, 107, however, at least partially avoid that the airflow (in case the tray 304 is removed from the housing 301) escapes through the opening left by the tray 304 and thus allows the replacement of the tray 304 (or the fans 302, 303 of the tray 304) to take longer as without such flow resisting means 101, 107 being present. In principle, the flow resisting means 101, 107 can be dimensioned such that overheating of the electronic equipment is avoided even in case the tray 304 is only removed, but not replaced at all.

It is noted that Fig.3 shows two trays 304, 307 as an example. There could be more than two trays arranged, e.g., in a bottom area, of a housing, wherein each of the trays comprises at least one fan and contributes to a cooling effect of a cooling area.

For example, several such trays can be located adjacent to one another in the housing (or chassis). The blockage effect of the flow resisting means (in case the airflow presses against the flow resisting means when the fans below the flow resisting means are inactive) can be approximately 30% or more. Advantageously, the flow resisting means are cheap and easy to produce and can be mounted in various ways. It is in particular an option to upgrade the flow resisting means to existing housings, if need would be.

It is also an advantage that only little space is required for this solution, which is a crucial issue, because the space inside the housing is to be used in an efficient manner. It is in particular an option to provide some space between the flow resisting means and the fan (e.g., 5cm to 10cm), to avoid unwanted effects due to propeller turbulences of the fan.

### List of References:

- 101: flow resisting means
- 102: frame
- 103: bar (or crosspiece)
- 104: bar (or crosspiece)
- 105: bar (or crosspiece)
- 106: protruding portion
- 107: flow resisting means
- 108: fastener
- 109: fastener
- 110: fastener
- 111: fastener
- 112: fastener
- 113: fastener
- 114: opening

- 201: airflow

- 301: housing
- 302: fan
- 303: fan
- 304: tray
- 305: fan
- 306: fan
- 307: tray
- 308: frame
- 309: frame

## Claims

1. Housing, in particular of a telecommunication device,
- comprising a flow resisting means (101, 107) between an active cooling device (302, 303, 305, 306) and a cooling area,
- wherein the flow resisting means (101, 107) is arranged such that it provides less flow resistance towards the cooling area than in the opposite direction
**characterized in that**
- the flow resisting means comprises a flexible part or a deformable part that is less rigid so that it is moveable towards the cooling area by an airflow.

2. The housing according to claim 1, wherein the active cooling device comprises at least one fan that is arranged on a replaceable unit.

3. The housing according to claim 2, wherein the housing is arranged to contain several replaceable units.

4. The housing according to any of the preceding claims,
wherein the flow resisting means comprises at least one layer, plate and/or foil.

5. The housing according to any of the preceding claims, wherein the flow resisting means is mounted on a frame.

6. The housing according to claim 5, wherein said flow resisting means comprises several laterally protruding portions, which are moveable towards the cooling area by an airflow.

7. The housing according to claim 6, wherein the laterally protruding portions in their end range lie on top of the frame so that they are moveable towards the cooling area by an airflow.

8. The housing according to any of claims 6 or 7, wherein the laterally protruding portions are arranged offset against each other, in particular at an alternating pattern.

9. The housing according to any of claims 6 to 8, wherein the laterally protruding portions cover a part of the flow cross-section, said flow cross-section being caused by the active cooling device.

10. The housing according to any of the preceding claims, wherein the housing comprises electronic equipment that is arranged within the cooling area.

11. The housing according to any of the preceding claims, wherein the flow resisting means is flexible or hinged towards the cooling area.

12. The housing according to any of the preceding claims, wherein the housing comprises a telecommunication equipment.

## Patentansprüche

1. Gehäuse, insbesondere einer Telekommunikationsvorrichtung, das Folgendes umfasst:
- ein Strömungswiderstandsmittel (101, 107) zwischen einer aktiven Kühlvorrichtung (302, 303, 305, 306) und einer Kühlfläche,
- wobei das Strömungswiderstandsmittel (101, 107) so angeordnet ist, dass es hin zur Kühlfläche für einen geringeren Strömungswiderstand als in der entgegengesetzten Richtung sorgt,
**dadurch gekennzeichnet, dass**
- das Strömungswiderstandsmittel einen flexiblen Teil oder einen verformbaren Teil umfasst, der weniger starr ist, so dass es durch eine Luftströmung hin zur Kühlfläche bewegbar ist.

2. Gehäuse nach Anspruch 1, bei dem die aktive Kühlvorrichtung mindestens einen Lüfter umfasst, der an einer auswechselbaren Einheit angeordnet ist.

3. Gehäuse nach Anspruch 2, wobei das Gehäuse so angeordnet ist, dass es mehrere auswechselbare Einheiten enthält.

4. Gehäuse nach einem der vorstehend aufgeführten Ansprüche, bei dem das Strömungswiderstandsmittel mindestens eine Schicht, Platte und/oder Folie umfasst.

5. Gehäuse nach einem der vorstehend aufgeführten Ansprüche, bei dem das Strömungswiderstandsmittel an einem Rahmen montiert ist.

6. Gehäuse nach Anspruch 5, bei dem das Strömungswiderstandsmittel mehrere seitlich überstehende Abschnitte umfasst, die durch eine Luftströmung hin zur Kühlfläche bewegbar sind.

7. Gehäuse nach Anspruch 6, bei dem die seitlich überstehenden Abschnitte in ihrem Endbereich oben auf dem Rahmen aufliegen, so dass sie durch eine Luftströmung hin zur Kühlfläche bewegbar sind.

8. Gehäuse nach einem der Ansprüche 6 oder 7, bei dem die seitlich überstehenden Abschnitte gegeneinander versetzt, insbesondere in einem abwechselnden Muster, angeordnet sind.

9. Gehäuse nach einem der Ansprüche 6 bis 8, bei dem die seitlich überstehenden Abschnitte einen Teil des Strömungsquerschnitts abdecken, wobei sich der Strömungsquerschnitt durch die aktive Kühlvorrichtung ergibt.

10. Gehäuse nach einem der vorstehend aufgeführten Ansprüche, bei dem das Gehäuse eine Elektronikeinrichtung umfasst, die innerhalb der Kühlfläche angeordnet ist.

11. Gehäuse nach einem der vorstehend aufgeführten Ansprüche, bei dem das Strömungswiderstandsmittel flexibel oder hin zur Kühlfläche angelenkt ist.

12. Gehäuse nach einem der vorstehend aufgeführten Ansprüche, bei dem das Gehäuse eine Telekommunikationseinrichtung umfasst.

## Revendications

1. Boîtier, en particulier d'un dispositif de télécommunication,
- comprenant un moyen de résistance à l'écoulement (101, 107) entre un dispositif de refroidissement actif (302, 303, 305, 306) et une zone de refroidissement,
- dans lequel le moyen de résistance à l'écoulement (101, 107) est agencé de telle sorte qu'il fournit une résistance à l'écoulement moindre vers la zone de refroidissement que dans le sens opposé,
**caractérisé en ce que**
- le moyen de résistance à l'écoulement comprend une partie souple ou une partie déformable qui est moins rigide de sorte qu'elle peut être déplacée vers la zone de refroidissement par un flux d'air.

2. Boîtier selon la revendication 1, dans lequel le dispositif de refroidissement actif comprend au moins un ventilateur qui est agencé sur une unité remplaçable.

3. Boîtier selon la revendication 2, dans lequel le boîtier est agencé de manière à contenir plusieurs unités remplaçables.

4. Boîtier selon l'une quelconque des revendications précédentes, dans lequel le moyen de résistance à l'écoulement comprend au moins une couche, plaque et/ou feuille.

5. Boîtier selon l'une quelconque des revendications précédentes, dans lequel le moyen de résistance à l'écoulement est monté sur un châssis.

6. Boîtier selon la revendication 5, dans lequel ledit moyen de résistance à l'écoulement comprend plusieurs parties faisant saillie latéralement, qui sont mobiles vers la zone de refroidissement par un flux d'air.

7. Boîtier selon la revendication 6, dans lequel les parties faisant saillie latéralement dans leur plage d'extrémité se situent sur le dessus du châssis de sorte qu'elles peuvent être déplacées vers la zone de refroidissement par un flux d'air.

8. Boîtier selon l'une quelconque des revendications 6 ou 7, dans lequel les parties faisant saillie latéralement sont agencées de manière décalée les unes contre les autres, en particulier au niveau d'un motif alterné.

9. Boîtier selon l'une quelconque des revendications 6 à 8, dans lequel les parties faisant saillie latéralement couvrent une partie de la section transversale d'écoulement, ladite section transversale d'écoulement étant provoquée par le dispositif de refroidissement actif.

10. Boîtier selon l'une quelconque des revendications précédentes, dans lequel le boîtier comprend un équipement électronique qui est agencé à l'intérieur de la zone de refroidissement.

11. Boîtier selon l'une quelconque des revendications précédentes, dans lequel le moyen de résistance à l'écoulement est souple ou articulé vers la zone de refroidissement.

12. Boîtier selon l'une quelconque des revendications précédentes, dans lequel le boîtier comprend un équipement de télécommunication.
